(19) Europäisches Patentamt
European Patent Office
Office européen des brevets

(11) **EP 1 947 703 B1**

(12) **EUROPEAN PATENT SPECIFICATION**

(45) Date of publication and mention
of the grant of the patent:
**14.08.2019 Bulletin 2019/33**

(51) Int Cl.:
*H01L 31/05* (2014.01)    *H01L 31/02* (2006.01)

(21) Application number: **06811582.3**

(22) Date of filing: **11.10.2006**

(86) International application number:
**PCT/JP2006/320275**

(87) International publication number:
**WO 2007/043562 (19.04.2007 Gazette 2007/16)**

(54) **INTERCONNECTOR, SOLAR BATTERY STRING USING SUCH INTERCONNECTOR**

VERBINDUNGSGLIED, SOLARBATTERIE-KETTE MIT EINEM SOLCHEN VERBINDUNGSGLIED

INTERCONNECTEUR, SERIE DE BATTERIES SOLAIRES UTILISANT UN TEL INTERCONNECTEUR

(84) Designated Contracting States:
**DE ES GB IT**

(30) Priority: **14.10.2005 JP 2005300529**
**16.12.2005 JP 2005363762**

(43) Date of publication of application:
**23.07.2008 Bulletin 2008/30**

(73) Proprietor: **Sharp Kabushiki Kaisha**
**Osaka-shi, Osaka 545-8522 (JP)**

(72) Inventors:
• **UMETANI, Yoshinobu**
**Nara 635-0055 (JP)**
• **KATAYAMA, Yoshio**
**Hiroshima 739-0144 (JP)**
• **OHBASAMI, Masahiro**
**Nara 639-0252 (JP)**
• **TAKEOKA, Sadaya**
**Nara 633-0003 (JP)**
• **SAGA, Tatsuo**
**Nara 636-0217 (JP)**

• **YAMAMOTO, Daiki**
**Nara 639-2122 (JP)**

(74) Representative: **Müller Hoffmann & Partner**
**Patentanwälte mbB**
**St.-Martin-Strasse 58**
**81541 München (DE)**

(56) References cited:
**DE-A1- 3 902 838        DE-A1- 4 330 282**
**JP-A- 01 198 082        JP-A- 02 271 561**
**JP-A- 03 262 314        JP-A- 06 196 744**
**JP-A- 55 095 376        JP-A- 60 042 854**
**JP-A- 60 261 161        JP-A- 62 016 579**
**JP-A- 62 112 381        JP-A- 63 187 657**
**JP-A- 2001 135 846      JP-A- 2002 319 691**
**JP-A- 2003 298 095      JP-A- 2004 193 444**
**JP-A- 2005 072 115      JP-A- 2005 142 282**
**JP-A- 2005 191 491      JP-U- 61 136 561**
**US-A- 6 034 322**

EP 1 947 703 B1

**Description**

TECHNICAL FIELD

The present invention relates to an interconnector connecting solar cells to each other, a solar cell string using the interconnector and a method of manufacturing the solar cell string, and a solar cell module using the solar cell string. More specifically, the invention relates to an interconnector with which a warp that occurs to each solar cell when the solar cells are connected by the interconnector can be reduced.

BACKGROUND ART

For solar cells converting solar energy directly into electrical energy, recently expectations have been remarkably growing for their availability as a next-generation energy source, particularly in terms of global environmental issues. Solar cells are classified into various kinds like the one using a compound semiconductor or the one using an organic material. Currently most solar cells use a silicon crystal which is a semiconductor. As photovoltaic power generation systems become rapidly widespread, reduction of the manufacturing cost of the solar cell becomes indispensable. For reducing the manufacturing cost of the solar cell, it is significantly effective to increase the size and reduce the thickness of a silicon wafer which is a semiconductor material.

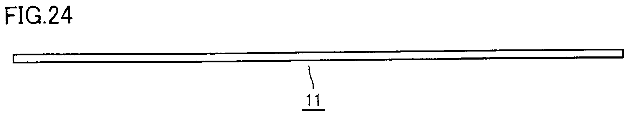

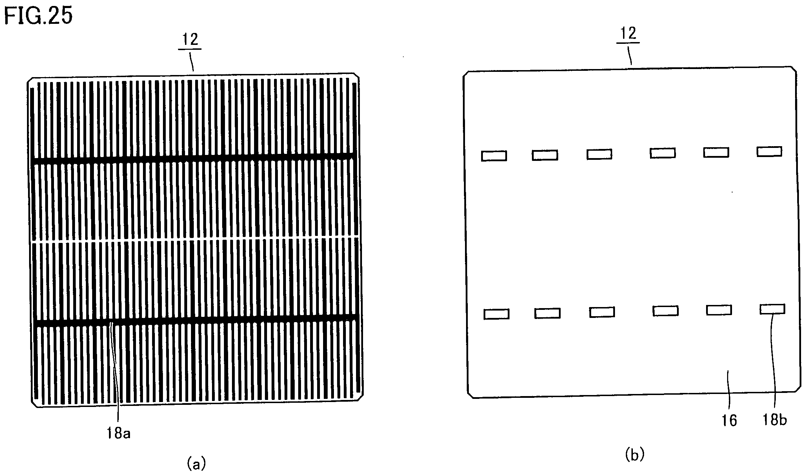

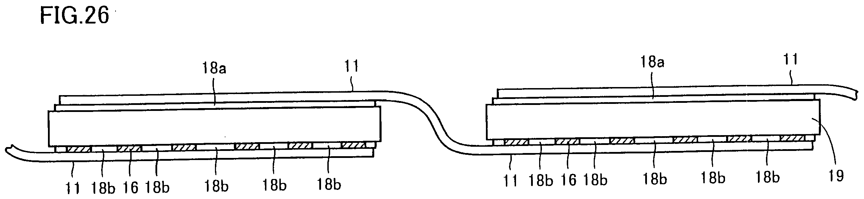

An increased size and a reduced thickness of the silicon wafer, however, are accompanied by the following problem. It is supposed that a conventionally-employed bobbin-wound interconnector whose 0.2% load is 13 to 15 kgf (interconnector: a long and thin electrically conductive member for electrically connecting solar cells adjacent to each other, see an interconnector 1 in Figs. 24 and 26) and electrodes (see electrodes 18a, 18b of Figs. 25, 26) of solar cells are used as they are for fabricating a solar cell string (see Fig. 26). In a heating process for connecting an electrode of a solar cell and the interconnector, there is a difference in thermal expansion coefficient between silicon which is a material for a substrate of the solar cell and copper which is a base material for the interconnector. As the temperature is decreased to room temperature, the solar cell is caused to warp greatly.

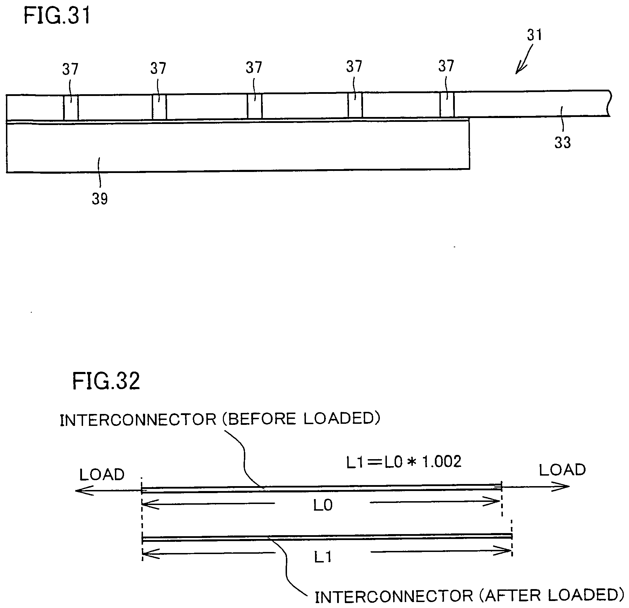

Here, "0.2% load" refers to the magnitude of tension required to cause the length of a wire rod to extend by 0.2%. As shown in Fig. 32, the 0.2% load corresponds to a tensile load causing the length after the load is applied to be L1 (1.002 times as long as length L0 before the load is applied).

Further, the warp occurring to the solar cell causes a transport error and a crack of the cell in a transport system included in an automated module fabrication line. Furthermore, in the state where a plurality of solar cells are electrically connected by an interconnector (hereinafter referred to as "string"), if each solar cell has a warp, a local strong force is applied to the solar cell, which is a component of the string, in a resin encapsulation process for fabricating a module, which causes the solar cell to crack.

In order to address such a problem, an interconnector is proposed (see for example Japanese Patent Laying-Open No. 2005-142282) that includes a long and thin electrically conductive member for electrically connecting respective electrodes of solar cells adjacent to each other. The conductive member has its opposite ends that are connecting portions connected to the electrodes of the solar cells. At least one connecting portion has a plurality of small cross-section parts where the cross-sectional area is locally decreased.

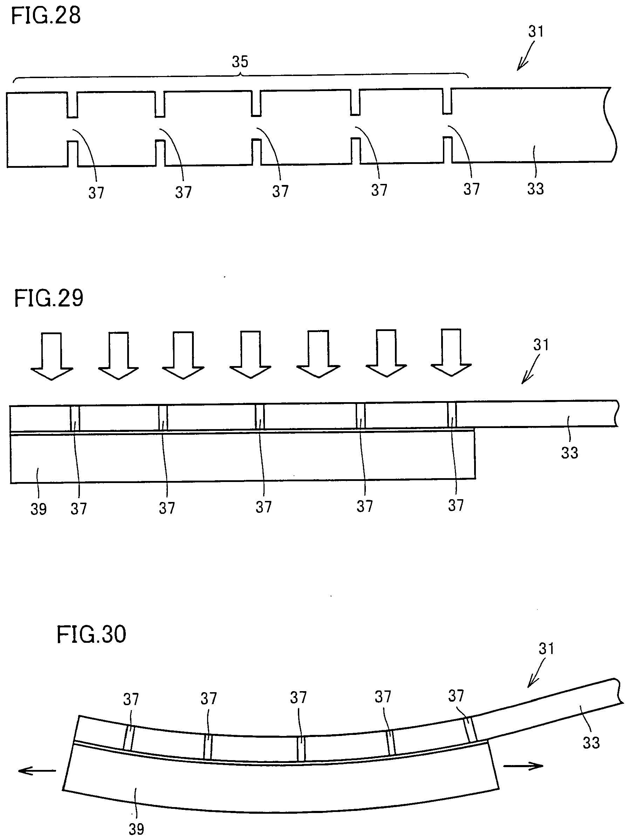

In the case where such an interconnector is used where at least one connecting portion of the interconnector has small cross-section parts arranged side by side in the longitudinal direction of the conductive member, the small cross-section parts having a relatively lower strength as compared with other portions extend because of its force of recovering its original shape of the solar cell. As a consequence of this, a warp occurring to the solar cell is reduced (see Figs. 28 to 32).

In addition, since the warp of the solar cell is reduced by the extension of the small cross-section parts as described above, the connecting portion of the interconnector can be joined to the entire surface of the electrode of the solar cell regardless of a thermal stress applied to the solar cell and thus the reliability after the cells are connected is enhanced.

Patent Document 1: Japanese Patent Laying-Open No. 2005-142282

According to DE 39 02 838 A1, an electrode is formed on a first region of a light receiving surface of a solar battery element and an end portion of an interconnector is connected to a part of the surface region of the electrode, while an adhesive layer is provided on the light receiving surface, the surface of the electrode and the end portion of the interconnector. Further, one or more through holes are provided in a region of the interconnector being adjacent to the end portion. Thus, even if an adhesive agent forming the adhesive layer flows out during formation of the adhesive layer, the outflow parts of the adhesive agent are trapped in the through holes, whereby the solar battery device can be reduced in size.

An interconnector disclosed in DE 43 30 282 A1 includes a first connecting portion connected to a front surface electrode of a solar cell, a second connecting portion connected to a rear surface electrode of another solar cell connected in serial direction, and a stress relief portion formed between the first connecting portion and the second connecting portion for absorbing displacement. The width of the first connecting portion in the parallel direction is made smaller than the width of the stress relief portion in the parallel direction. By this structure, the width of the front surface electrode of the solar cell can be reduced, the effective light receiving area of the solar cell can be increased, and therefore the efficiency in generating power can be improved.

Interconnect members of US 6 034 322 A mount a protective bypass diode, electrically intermediate and in series with first and second conductor members, on a solar cell in a mutually coplanar relationship proximate to but spaced from a beveled edge, accommodating relative in-plane motion between the bypass diode and the solar cell. The interconnect members include an upper interconnect member extending between and fixed, respectively, to a first metallic pad member on the first opposed surface adjacent the beveled edge and electrically connected to the bus member and to a first surface of the bypass diode and a lower interconnect member extending between and fixed, respectively, to a second metallic pad member mounted adjacent the beveled edge and electrically connected to the metallic coating and to a second surface of the bypass diode.

DISCLOSURE OF THE INVENTION

PROBLEMS TO BE SOLVED BY THE INVENTION

In a process of manufacturing a solar cell module using the above-described interconnector, because of a thermal history or the like in a heating process for connecting electrodes of solar cells and the interconnector for example, a problem arises that expansion and contraction in the longitudinal direction of the interconnector are locally concentrated on the small cross-section parts where the size is locally smaller of the interconnector. Therefore, in order to disperse the forces of expansion and contraction, many small cross-section parts have to be processed, leading to an increase in manufacturing cost of the interconnector itself, which is not desirable.

Further, because of a thermal cycle in the process of connecting an interconnector, in the process of forming a solar cell module or after the module is completed and installed, or because of softening and flowing of an encapsulating resin for a solar cell module, a stress occurs in the longitudinal direction of the interconnector. In the case where such a stress occurs to the interconnector having a locally reduced cross-section, the stress in this direction is locally concentrated on this small cross-section part, resulting in a possibility that the interconnector is broken. Therefore, the above-described conventional interconnector has the problem that a long-term reliability cannot be ensured.

Furthermore, although an interconnector including a long and thin electrically conductive member can be easily stored in continuously reeled state, a tension is concentrated on a small cross-section part having a locally reduced size, when the interconnector is reeled or unreeled. Therefore, there is the problem that the interconnector is damaged and deformed, leading to a manufacture error.

Moreover, there is also the possibility that notches of the interconnector interfere with each other and thus smooth reeling and unreeling of the interconnector cannot be done efficiently. If the interconnector is forced to be set on a cell in spite of the fact that any notch is caught on something, the interconnector is damaged and deformed. In addition, there is the problem that a transport error could occur in a transport system for feeding an interconnector in a module fabrication line.

The present invention has been made in view of the above-described issues, and an object of the invention is to provide an interconnector with which a warp occurring to a solar cell after the interconnector is connected to the solar cell can be reduced, and which has an excellent reliability after connected.

MEANS FOR SOLVING THE PROBLEMS

The invention is defined by the appended claims. References to embodiments which do not fall under the scope of the claims are to be understood as examples useful for understanding the invention.

In an aspect, an interconnector of the present disclosure solving the above-described problems is an interconnector electrically connecting respective electrodes to each other of solar cells adjacent to each other, and the interconnector includes a strip-shaped and electrically conductive member including a stress relief part. The stress relief part is planar and has a notch forming an obtuse angle at a lateral end or is linear at a lateral end.

In an embodiment of the interconnector of the present disclosure, the conductive member includes a plurality of planar stress relief parts. Further, a plurality of conductive members are continuously stored in reeled state.

In another embodiment, the interconnector of the present disclosure includes an electrically conductive member for electrically connecting respective electrodes of solar cells adjacent to each other, at least a part of the conductive member is to be connected to an electrode of a solar cell and at least another part of the conductive member includes a small cross-section part where a cutout is made such that a lateral cross section is divided into opposite lateral end portions.

In still another embodiment of the interconnector of the present disclosure, at least a part of the conductive member is connected to an electrode of a solar cell and at least another part of the conductive member includes a notch cut out from a side surface portion to have a small cross-section part where a cross-sectional area is continuously reduced.

At least a part of the notch of the present disclosure includes a curved portion, or the notch includes a portion that is cut obliquely with respect to a longitudinal direction of the conductive member. Further, in an embodiment of the present invention, the plurality of notches are cut point symmetrically or line symmetrically.

A solar cell string to which the above-described interconnector is applied includes solar cells including respective electrodes and adjacent to each other and the interconnector electrically connecting the electrodes of the solar cells adjacent to each other.

A method of manufacturing the solar cell string of the present disclosure includes the step of connecting an electrode of a solar cell and the interconnector by any one of heater heating, lamp heating and reflow method.

A solar cell module of the present disclosure includes an encapsulating material encapsulating the solar cell string and a pair of external terminals extending outward from the solar cell string through the encapsulating material.

In a further aspect, an interconnector of the present disclosure solving the above-described problems includes a strip-shaped and electrically conductive member for electrically connecting respective electrodes to each other of solar cells adjacent to each other, and the conductive member has a 0.2% load of not more than 10 kgf.

In an embodiment of the interconnector of the present disclosure, a semiconductor substrate of a solar cell has a thickness of not more than 180 $\mu$m and the conductive member has a 0.2% load of not more than 10 kgf. In another embodiment of the interconnector of the present invention, a semiconductor substrate of a solar cell has a thickness of not more than 160 $\mu$m and the conductive member has a 0.2% load of not more than 6.5 kgf. In still another embodiment of the interconnector of the present invention, a semiconductor substrate of a solar cell has a thickness of not more than 120 $\mu$m and the conductive member has a 0.2% load of not more than 3.0 kgf. Further, in an embodiment of the present invention, a plurality of conductive members are continuously wound on a reel and stored.

A method of manufacturing the solar cell string of the present disclosure includes the step of connecting an electrode of a solar cell and the interconnector by any one of heater heating, lamp heating and reflow method. A solar cell module of the present invention includes an encapsulating material encapsulating the solar cell string and a pair of external terminals extending outward from the solar cell string through the encapsulating material.

In a further aspect, an interconnector of the present disclosure solving the above-described problems includes a strip-shaped and electrically conductive member for electrically connecting respective electrodes to each other of solar cells adjacent to each other, and the conductive member has a 0.2% tensile stress of not more than 7.5 kgf/mm$^2$.

EFFECTS OF THE INVENTION

With the interconnector of the present invention, a stress due to a difference in thermal expansion coefficient between the interconnector and a solar cell is remarkably alleviated. Consequently, a warp occurring to the solar cell is reduced and the reliability of connection between the interconnector and the solar cell is improved. Further, a stress relief part is planer and has a notch having a lateral end forming an obtuse angle or has a linear lateral end. Therefore, the stress relief part of the interconnector can have the structure that is unlikely to be caught on something.

Further, since the warp of the solar cell is reduced as described above, a transportation error and a cell crack in a transport system of a module fabrication line can be prevented from occurring. Furthermore, since a cell crack in a resin encapsulation process for fabricating a module is also prevented, the yield and productivity of solar cell modules are improved.

Moreover, since breakage of the interconnector in a setting process, heat treatment process or resin encapsulation process for example for fabricating a module is also prevented, the yield and productivity of solar cell modules are improved.

BRIEF DESCRIPTION OF THE DRAWINGS

Fig. 1 shows an example of the shape of a small cross-section part in the case where a lateral cross section of a conductive member is rectangular in a first embodiment of the invention, (a) is a front view, (b) is a side view and (c) is a bottom view.

Fig. 2 shows another example of the shape of a small cross-section part in the case where a lateral cross section of a conductive member is rectangular in the first embodiment of the invention, (a) is a front view, (b) is a side view and (c) is a bottom view.

Fig. 3 shows still another example of the shape of a small cross-section part in the case where a lateral cross section of a conductive member is rectangular in the first embodiment of the intention, (a) is a front view, (b) is a side view, (c) is a bottom view and (d) is an enlarged view of a stress relief part.

Fig. 4 shows a further example of the shape of a small cross-section part in the case where a lateral cross section of a conductive member is rectangular in the first embodiment of the intention, (a) is a front view, (b) is a side view and (c) is a bottom view.

Fig. 5 shows a further example of the shape of a small cross-section part in the case where a lateral cross section of a conductive member is rectangular in the first embodiment of the intention, (a) is a front view, (b) is a side view and (c) is a bottom view.

Fig. 6 shows a further example of the shape of a small cross-section part in the case where a lateral cross section of a conductive member is rectangular in the first embodiment of the intention, (a) is a front view, (b) is a side view and (c) is a bottom view.

Fig. 7 shows a further example of the shape of a small cross-section part in the case where a lateral cross section of a conductive member is rectangular in the first embodiment of the intention, (a) is a front view, (b) is a side view and (c) is a bottom view.

Fig. 8 shows a further example of the shape of a small cross-section part in the case where a lateral cross section of a conductive member is rectangular in the first embodiment of the intention, (a) is a front view, (b) is a side view and (c) is a bottom view.

Fig. 9 shows a further example of the shape of a small cross-section part in the case where a lateral cross section of a conductive member is rectangular in the first embodiment of the intention, (a) is a front view, (b) is a side view and (c) is a bottom view.

Fig. 10 shows a further example of the shape of a small cross-section part in the case where a lateral cross section of a conductive member is rectangular in the first embodiment of the intention, (a) is a front view, (b) is a side view and (c) is a bottom view.

Fig. 11 shows a further example of the shape of a small cross-section part in the case where a lateral cross section of a conductive member is rectangular in the first embodiment of the intention, (a) is a front view, (b) is a side view and (c) is a bottom view.

Fig. 12 shows a further example of the shape of a small cross-section part in the case where a lateral cross section of a conductive member is rectangular in the first embodiment of the intention, (a) is a front view, (b) is a side view and (c) is a bottom view.

Fig. 13 shows a further example of the shape of a small cross-section part in the case where a lateral cross section of a conductive member is rectangular in the first embodiment of the intention, (a) is a front view, (b) is a side view and (c) is a bottom view.

Fig. 14 shows a further example of the shape of a small cross-section part in the case where a lateral cross section of a conductive member is rectangular in the first embodiment of the intention, (a) is a front view, (b) is a side view and (c) is a bottom view.

Fig. 15 is a plan view showing an interconnector in a second embodiment of the invention.

Fig. 16 shows a solar cell in the second embodiment of the invention, (a) is a front view and (b) is a rear view.

Fig. 17 illustrates a solar cell string in the second embodiment of the invention.

Fig. 18 illustrates a solar cell module in the second embodiment of the invention.

Fig. 19 shows Graphs 1 to 3 of data in Tables 1 to 3 regarding an interconnector in a third embodiment of the invention.

Fig. 20 shows Graph 4 of a relation between a thickness B of a semiconductor substrate and a 0.2% load F in the case where C/A is 4.0%, and Graph 5 of data in Table 5.

Fig. 21 shows an interconnector in an enlarged state in a fourth embodiment of the invention, (a) is a front view, (b) is a side view and (c) is a bottom view.

Fig. 22 illustrates that the interconnector shown in Fig. 21 is connected to a light receiving surface electrode and a rear electrode of solar cells.

Fig. 23 shows a solar cell module using a solar cell string in a fifth embodiment of the invention.

Fig. 24 is a plan view showing an example of a conventional interconnector.

Fig. 25 shows an example of a conventional solar cell, (a) shows a front side and (b) shows a rear side.

Fig. 26 illustrates a conventional solar cell string.

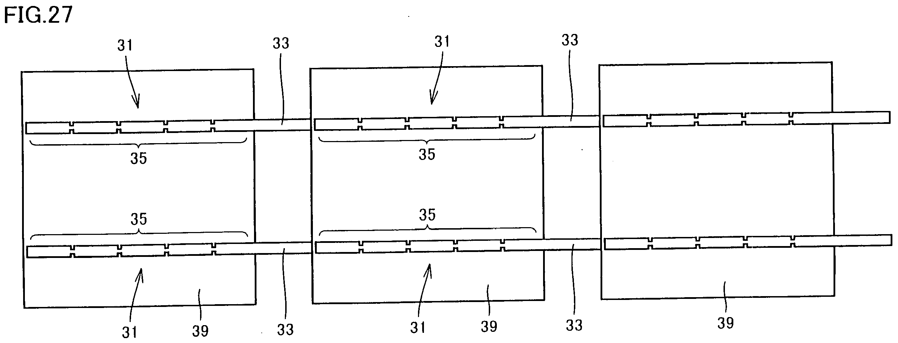

Fig. 27 shows solar cells connected by a conventional interconnector.

Fig. 28 is an enlarged view of a connecting portion of a conventional interconnector.

Fig. 29 illustrates that a conventional interconnector is joined to an electrode of a solar cell by applying heat.

Fig. 30 illustrates that the conventional interconnector joined by applying heat is cooled to room temperature, causing the solar cell to warp.

Fig. 31 illustrates that small cross-section parts of the conventional interconnector extend to reduce the warp of the solar cell.

Fig. 32 illustrates the definition of a 0.2% load.

Fig. 33 illustrates the definition of a wafer warp amount C.

DESCRIPTION OF THE REFERENCE SIGNS

1, 11, 21, 31 interconnector, 2, 12, 20 solar cell, 3, 33 conductive member, 3a, 3b side surface of conductive member, 6, 16 aluminum electrode, 7, 37 small cross-section part, 8a, 18a light-receiving surface electrode, 8b, 18b, rear electrode, 9, 19, 39 solar cell, 22 solar cell string, 23 solar cell module, 24 encapsulating material, 25 surface protection layer, 26 rear film, 27, 28 external terminal, 29 frame, 35 connecting portion

BEST MODES FOR CARRYING OUT THE INVENTION

First Embodiment

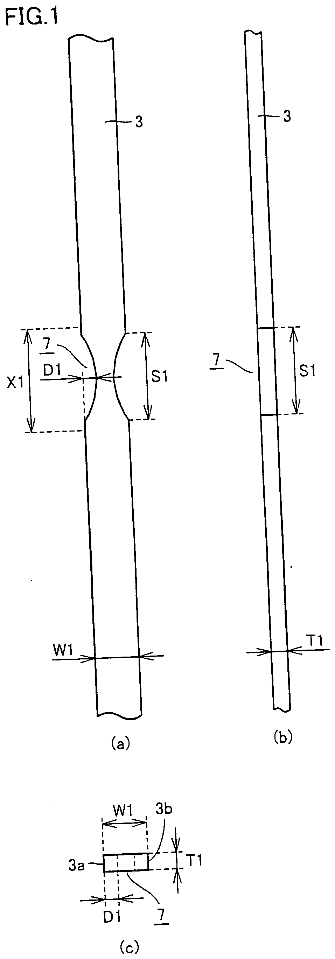

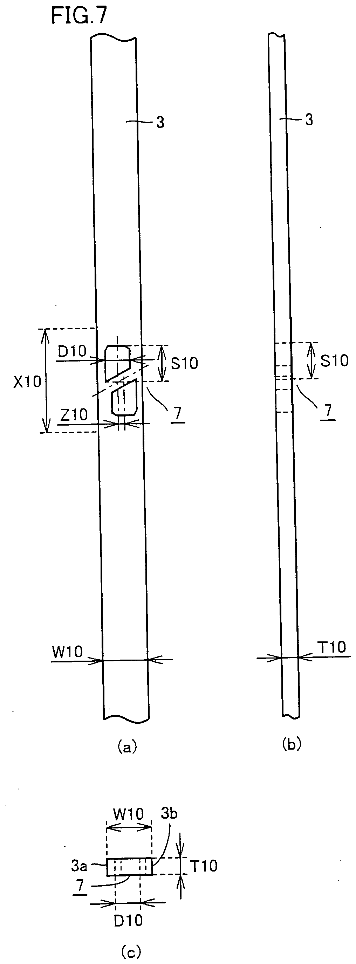

In the following, a first embodiment of an interconnector of the present invention will be described with reference to Figs. 1 to 14.

The interconnector of the present invention is formed using a strip-shaped and electrically conductive member 3, and conductive member 3 is preferably linear-shaped. More preferably, a stress relief part is planar-shaped and may be arranged in parallel with respect to a surface of a solar cell without a space therebetween. Conductive member 3 includes at least one stress relief part for alleviating expansion and contraction stresses, and the stress relief part is structured such that the stress relief part is unlikely to be caught on something.

More preferably, in order to prevent a force from being concentrated locally in the stress relief part, the stress relief part has its cross section whose cross-sectional area continuously changes in the longitudinal direction of the interconnector. Alternatively, in order to prevent a force from being concentrated locally in the stress relief part, the stress relief part has its cross section whose cross-sectional area is divided.

Further, it is desirable to use an interconnector including notches arranged such that an expansion or contraction stress at the stress relief part is exerted obliquely relative to the longitudinal direction. Furthermore, it is desirable to use an interconnector including notches arranged such that an expansion or contraction stress at the stress relief part is dispersed.

Moreover, preferably the stress relief part of the interconnector is coordinated with an electrode pattern of a solar cell, and desirably the stress relief part is not physically connected to an electrode of a solar cell. Here, a solar cell 2 includes those formed using an elemental semiconductor such as amorphous silicon, polycrystalline silicon and monocrystalline silicon and a compound semiconductor such as GaAs, for example.

Preferably conductive member 3 is made of a strip-shaped electrically conductive material in the form of a foil or sheet and preferably made of an electrically conductive material formed such that the material can be stored in a reeled state. In the case where the conductive member is strip-shaped, its width W is preferably approximately 0.5 to 5.0 mm, more preferably approximately 0.5 to 3.0 mm and particularly preferably approximately 2.5 mm Thickness T is preferably approximately 0.05 to 0.5 mm, more preferably approximately 0.05 to 0.3 mm and particularly preferably approximately 0.2 mm.

One end or both ends of the conductive member may be divided into multiple portions. For example, in the case where one of solar cells adjacent to each other has its light-receiving surface where a plurality of electrodes are provided and the other solar cell has its rear surface where one electrode is provided, preferably an interconnector is used that is formed using a conductive member having one end divided into a plurality of portions.

The conductive member includes various metals and alloys. Specifically, the conductive member includes metals such as Au, Ag, Cu, Pt, Al, Ni and Ti as well as alloys of them. In particular, Cu is preferably used. Preferably, the conductive member is solder-plated. A solder-plated interconnector is surely connected with a silver electrode of a solar cell. Solder plating may be done after a small cross-section part is formed or before a small cross-section part is formed.

Each small cross-section part 7 refers to a portion having a cross-sectional area smaller than that of most parts of the interconnector. Specifically, the small cross-section part refers to a small-width portion or a small-diameter portion formed by cutting out a part of a connecting portion. A method of cutting out a part of the connecting portion includes a method using mechanical cutting or polishing, a method using punching with a die and a method performing etching, for example.

Since small cross-section part 7 has a lower strength against expansion and contraction stresses as compared with most parts of the interconnector, the small cross-section part is extended by a relatively weak force. Therefore, the small cross-section part contributes to reduction of a warp of the solar cell by extension of the solar cell with its resilience of recovering its original shape.

Although increase of the electrical resistance of the interconnector as a result of providing a small cross-section part may be a concern, the length of each small cross-section part in the longitudinal direction of the conductive member may be made significantly smaller than the whole length of the interconnector so as to reduce the increase of the electrical resistance of the interconnector as a whole to an ignorable degree.

A small cross-section part may be formed between solar cells adjacent to each other. Thus, in the case where the distance between the solar cells adjacent to each other changes, the small cross-section part extends to alleviate a stress applied between the solar cells and the interconnector.

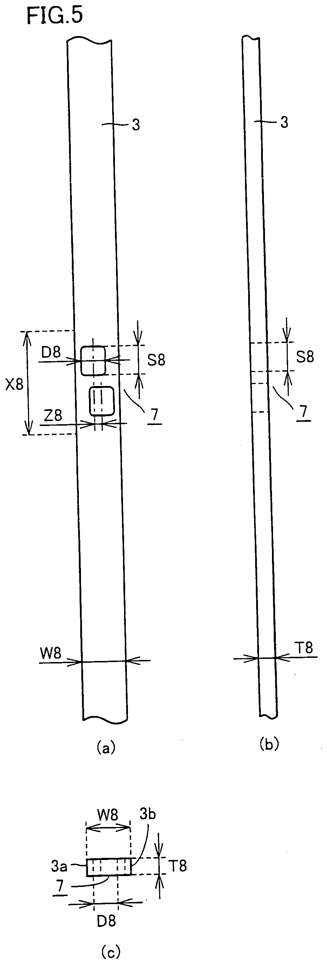

The small cross-section part of the interconnector of the present invention may have for example any of respective shapes shown in Figs. 1 to 11. The interconnectors in Figs. 1 to 4 show examples of the shape where a conductive member has a rectangular cross section, and a pair of notches formed by being cut out from opposite side surfaces of the conductive member for example form a small cross-section part. Figs. 5 to 11 show examples of the shape where a conductive member has a rectangular cross section, and notches formed inside the interconnector form a cross-sectional area portion.

As shown in Fig. 1, small cross-section part 7 is formed by cutting out two opposite side surfaces 3a and 3b of conductive member 3 such that the side surfaces are curved toward each other with a dimension in the longitudinal direction of the interconnector of S1 and a dimension in the widthwise direction thereof of D1. Accordingly, a stress relief part X1 has its cross section whose cross-sectional area continuously changes in the longitudinal direction of the interconnector.

Here, in the case where the conductive member is sheet-shaped and has its width W1 of approximately 2.5 mm and its thickness T1 of approximately 0.20 mm, it is particularly preferable that S1 is approximately 2 to 5 mm and D1 is approximately 0.5 to 1.0 mm. Preferably, a minimum width of small cross-section part 7 is approximately 0.5 to 1.5 mm.

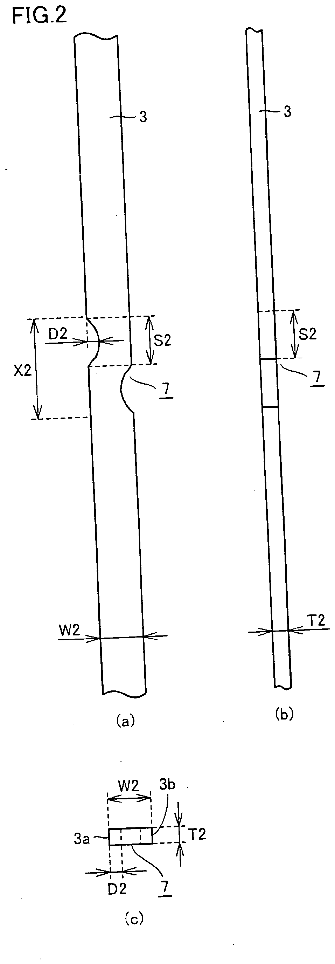

As shown in Fig. 2, small cross-section part 7 is formed by cutting out two opposite side surfaces 3a and 3b of conductive member 3 such that the side surfaces are curved alternately in the longitudinal direction with a dimension in the longitudinal direction of the interconnector of S2 and a dimension in the widthwise direction thereof of D2. Accordingly, a stress relief part X2 has its cross section whose cross-sectional area continuously changes in the longitudinal direction of the interconnector.

Although Fig. 2 shows an example where the notches do not overlap in the longitudinal direction, the notches may partially overlap in the longitudinal direction.

Here, in the case where the conductive member is sheet-shaped and has its width W2 of approximately 2.5 mm and its thickness T2 of approximately 0.20 mm, it is particularly preferable that S2 is approximately 1 to 5 mm and D2 is approximately 0.5 to 1.5 mm. Preferably, a minimum width of small cross-section part 7 is approximately 0.5 to 1.5 mm.

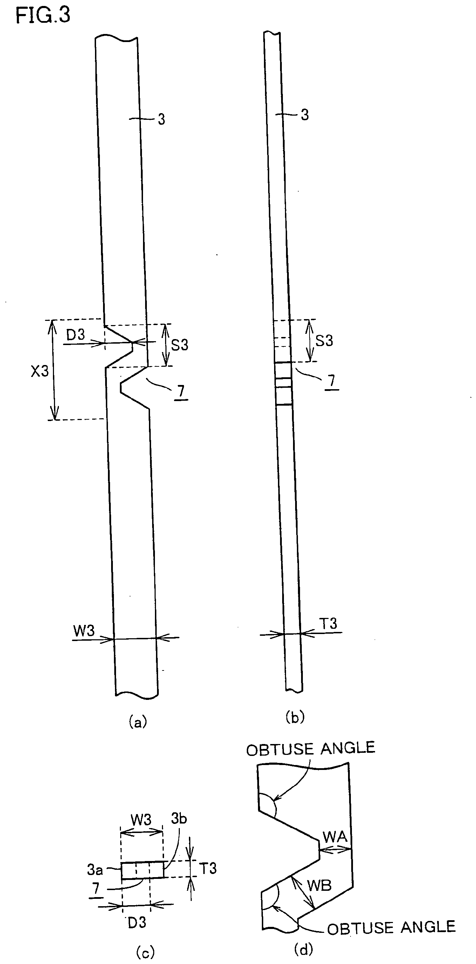

As shown in Fig. 3, small cross-section part 7 is formed by cutting out two opposite side surfaces 3a and 3b of conductive member 3 such that they are bend-shaped alternately in the longitudinal direction with a dimension in the longitudinal direction of the interconnector of S3 and a dimension in the widthwise direction thereof of D3. Accordingly, a stress relief part X3 has its cross section whose cross-sectional area continuously changes in the longitudinal direction of the interconnector.

Although Fig. 3 shows an example where the notches do not overlap in the longitudinal direction, the notches may partially overlap in the longitudinal direction. Although the shape of the notch is trapezoidal in this example, the notch may be curved at its corner. Further, the pair of trapezoidal notches provided on the right and left sides respectively has respective parallel oblique sides of the notches, and small cross-section part 7 is formed between the oblique sides. Thus, small cross-section part 7 extends obliquely relative to the longitudinal direction. Since the notch is trapezoidal and the angle formed by the side surface of the conductive member and the oblique side of the trapezoidal notch is obtuse (angle), the stress relief part of the interconnector has its structure unlikely to be caught on something. Specifically, in the case where the continuous interconnector is wound on a reel or unwound from the reel, or in the case where the interconnector is set for connecting the interconnector to a solar cell in a process of manufacturing a module, for example, interference between interconnectors and interference between an interconnector and another component can be avoided. In other words, damages such as deformation or breakage of the interconnector itself can be reduced or avoided that is caused by an excessive stress on the interconnector or a stress generated when the interconnector is caught before the interconnector is connected to a solar cell.

Here, in the case where the conductive member is sheet-shaped and has its width W3 of approximately 2.5 mm and its thickness T3 of approximately 0.20 mm, it is particularly preferable that S3 is approximately 1 to 5 mm and D3 is approximately 0.5 to 1.5 mm Preferably, a minimum width of small cross-section part 7 is approximately 0.5 to 1.5 mm.

Preferably, width WB of the small cross-section part that is defined by oblique sides facing each other of the opposite trapezoidal notches and width WA of the small sectional area portion that is defined by the side surface of the strip-shaped conductive member and the upper side of the trapezoidal notch facing the side surface have the relation WB > WA. Thus, a plurality of (two in the present embodiment) small cross-section parts with width WA extend so that the interconnector can be easily changed in shape in the longitudinal direction and the extension can be dispersed over a plurality of portions. Further, since the interconnector in Fig. 3 is point-symmetric, the extension can be efficiently dispersed.

Here, all of stress relief parts X1 to X3 of the interconnectors in the embodiment shown in Figs. 1 to 3 have an obtuse angle formed by the notch and the lateral end. Thus, the stress relief part can be structured such that the stress relief part is unlikely to be caught on something.

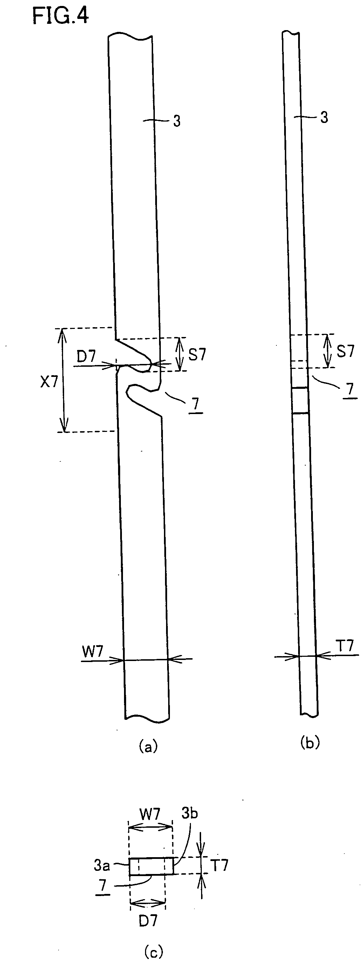

As shown in Fig. 4, small cross-section part 7 is formed by cutting out two opposite side surfaces 3a and 3b of conductive member 3 such that the side surfaces are slit-shaped alternately in the longitudinal direction and obliquely to the longitudinal direction with a dimension in the longitudinal direction of the interconnector of S7 and a dimension in the widthwise direction thereof of D7, and the slit-shaped notch has a round-shaped opening portion. Accordingly, a stress relief part X7 has its cross section whose cross-sectional area continuously changes in the longitudinal direction of the interconnector. Regarding this shape, although it is preferable that an end portion of the slit-shaped notch is curved, the end portion of the notch may be rectangular in shape. Further, it is preferable that respective directions of the slit-shaped notches are the same direction and small cross-section part 7 obliquely extends in the opposite direction with respect to the longitudinal direction.

Here, in the case where the conductive member is sheet-shaped and has its width W7 of approximately 2.5 mm and its thickness T7 of approximately 0.20 mm, it is particularly preferable that S7 is approximately 0.1 to 2 mm and D7 is approximately 1 to 2.0 mm. Preferably, a minimum width of small cross-section part 7 is approximately 0.5 to 1.5 mm.

As shown in Fig. 5, small cross-section part 7 includes two notches in the longitudinal direction, the notches are formed by cutting out the inner plane of conductive member 3 in the shape of a rectangle with a dimension in the longitudinal direction of S8 and a dimension in the widthwise direction of D8, and the notches are displaced from each other in the widthwise direction. The rectangular notches are made in the inner plane of conductive member 3 to divide the interconnector. Accordingly, a stress relief part X8 has its cross section whose cross-sectional area dispersedly changes. In the case where a corner of the rectangular notch is curved, stress relief part X8 also has its cross section whose cross-sectional area continuously changes in the longitudinal direction of the interconnector. In this example, two rectangular notches are cut out in the longitudinal direction from the inner plane of conductive member 3 and the notches are displaced from each other in the widthwise direction. However, the notches may be more than two. Further, the notches may not be displaced from each other in the widthwise direction.

In the case where two notches are displaced from each other in the widthwise direction, a small cross-section part having a smaller cross-sectional area mainly extends in the longitudinal direction. Since the current path is a cross-sectional area portion having a larger cross-sectional area, change of the cross-sectional area due to extension is smaller and stable. Thus, the interconnector can efficiently collect generated electric power.

Here, in the case where the conductive member is sheet-shaped and, has its width W8 of approximately 2.5 mm and its thickness T8 of approximately 0.20 mm, it is particularly preferable that S8 is approximately 0.1 to 2 mm and D8 is approximately 1 to 2.0 mm Preferably, Z8 is 0 to 0.5 mm and a minimum width of small cross-section part 7 is approximately 0.25 to 1.5 mm

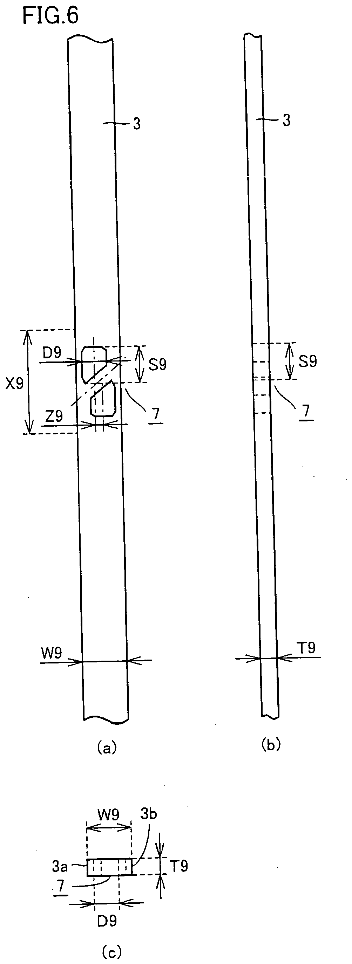

Regarding the interconnector shown in Fig. 6, small cross-section part 7 includes two notches in the longitudinal direction that are cut out in the shape of a trapezoid from an inner plane of conductive member 3 with a dimension in the longitudinal direction of the interconnector of S9 and a dimension in the widthwise direction of D9, and these notches are displaced from each other in the widthwise direction. Since the trapezoidal notches are provided in the inner plane of conductive member 3, the interconnector is divided and a stress relief part X9 has its cross section whose cross-sectional area dispersedly changes. Further, the oblique sides of the trapezoidal notches are inclined approximately 45 degrees with respect to the longitudinal direction and are disposed to face each other. Thus, stress relief part X9 also has its cross section whose cross-sectional area continuously changes in the longitudinal direction of the interconnector. Fig. 6 shows that two trapezoidal notches that are cut out from the inner plane of conductive member 3 are disposed in the longitudinal direction and the trapezoidal notches are displaced from each other in the widthwise direction, and accordingly small cross-sectional area 7 is inclined with respect to the longitudinal direction.

Although the oblique sides of the trapezoidal notches of the interconnector as shown are inclined approximately 30 degrees with respect to the longitudinal direction, the angle of inclination may be set appropriately.

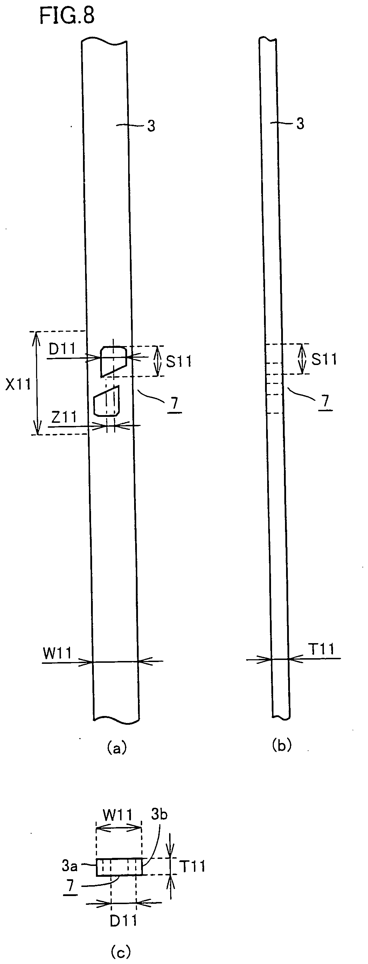

Further as shown in Fig. 8, the trapezoidal notches are displaced in the widthwise direction in the opposite direction relative to the interconnector shown in Fig. 6, and accordingly small cross-section part 7 is inclined in the opposite direction with respect to the longitudinal direction.

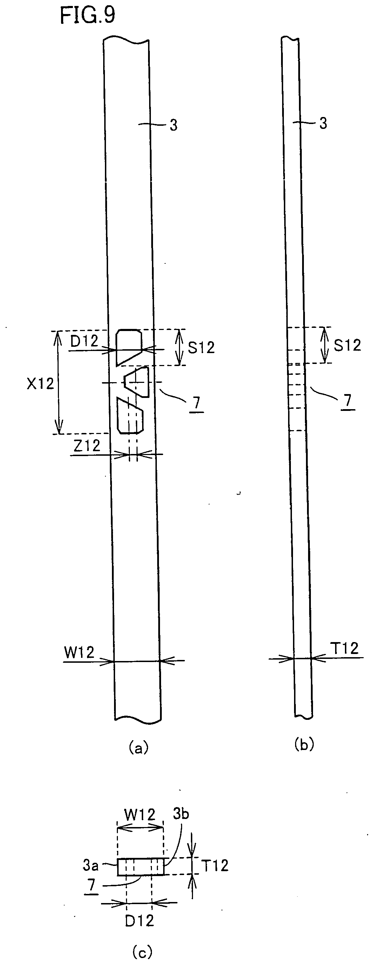

Furthermore, as shown in Fig. 9, notches of the interconnector may be three or more and they may not be displaced from each other in the widthwise direction. Preferably a corner of the trapezoidal notches is curved in shape.

Here, in the case where the conductive member is sheet-shaped and has its width W9, W10, W11, W12 of approximately 2.5 mm and its thickness T9, T10, T11, T12 of approximately 0.20 mm, it is particularly preferable that S9, S10, S11, S12 are approximately 0.1 to 3 mm and D9, D10, D11, D12 are approximately 1 to 2.0 mm. Preferably, Z9, Z10, Z11, Z12 are 0 to 0.5 mm and a minimum width of small cross-section part 7 is approximately 0.25 to 1.5 mm.

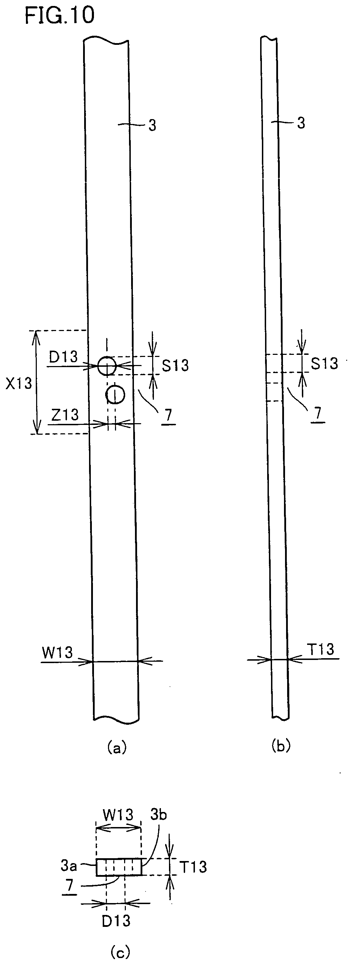

As shown in Fig. 10, small cross-section part 7 includes two circular notches in the longitudinal direction that are cut out from the inner plane of conductive member 3 with a dimension in the longitudinal direction of the interconnector of S13 and a dimension in the widthwise direction of D13. Since circular notches are cut in the inner plane of conductive member 3, the interconnector is divided and accordingly a stress relief part X13 has its cross section whose cross-sectional area dispersedly changes. Further, the cross section of stress relief part X13 also has a cross-sectional area continuously changes in the longitudinal direction of the interconnector.

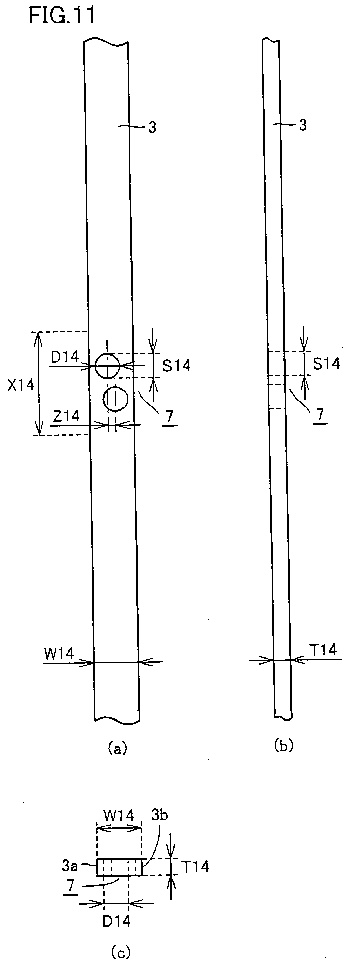

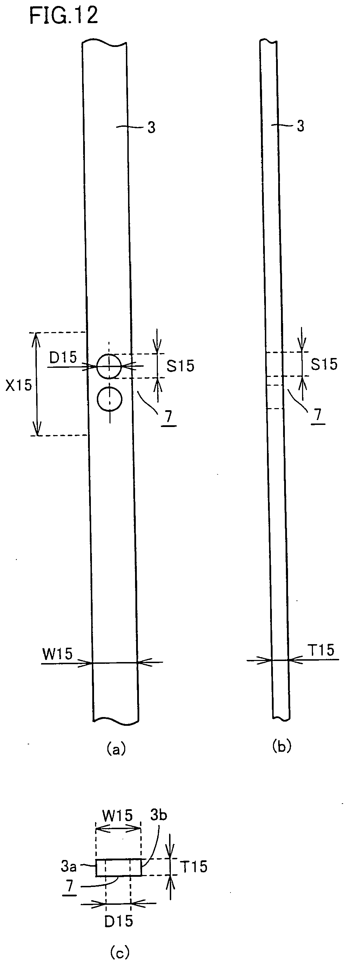

Notches may be displaced from each other in the widthwise direction as shown in Figs. 10 and 11 or disposed without displaced from each other in the widthwise direction as shown in Fig. 12. Further, notches may have an elliptical shape instead of the circular shape and the major axis may be oblique with respect to the longitudinal direction.

Here, in the case where the conductive member is sheet-shaped and has its width W13, W14, W15 of approximately 2.5 mm and its thickness T13, T14, T15 of approximately 0.20 mm, it is particularly preferable that S13, S14, S15 are approximately 1 to 3 mm and D13, D14, D15 are approximately 1 to 2.0 mm. Preferably, Z13, Z14 are 0 to 0.5 mm and a minimum width of small cross-section part 7 is approximately 0.25 to 1.5 mm

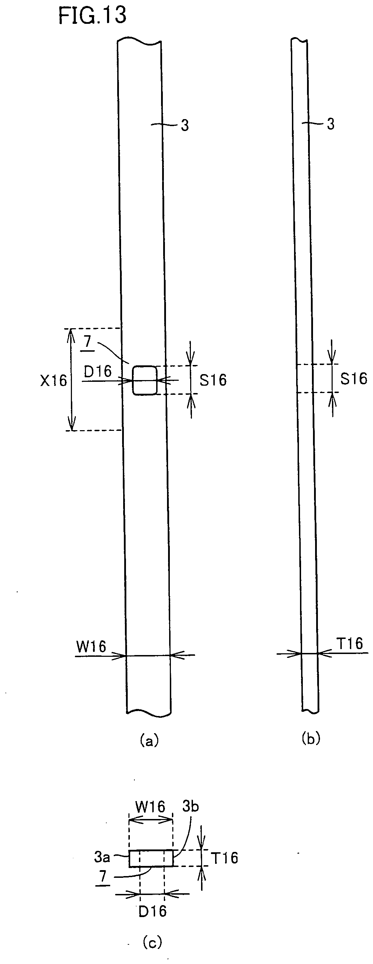

Regarding the interconnector shown in Fig. 13, small cross-section part 7 includes one rectangular notch that is cut out from an inner plane of conductive member 3 with a dimension in the longitudinal direction of the interconnector of S16 and a dimension in the widthwise direction of D16. Since the rectangular notch is provided in the inner plane of conductive member 3, the interconnector is divided and a stress relief part X16 has its cross section whose cross-sectional area dispersedly changes.

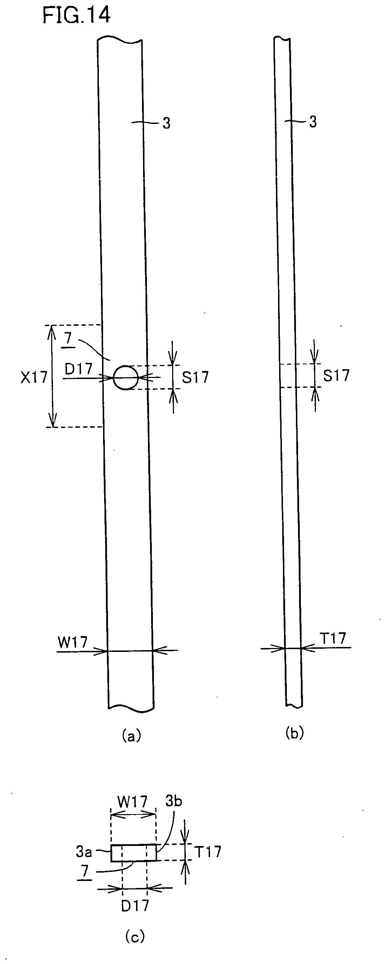

Further, regarding the interconnector shown in Fig. 14, small cross-section part 7 includes one circular notch that is cut out from an inner plane of conductive member 3 with a dimension in the longitudinal direction of the interconnector of S17 and a dimension in the widthwise direction of D17. Since the circular notch is provided in the inner plane of conductive member 3, the interconnector is divided and a stress relief part X16 has its cross section whose cross-sectional area changes dispersedly and continuously in the longitudinal direction of the interconnector.

The notch may be elliptical instead of circular in shape, and the major axis may be oblique with respect to the longitudinal direction.

The examples of Figs. 13 and 14 are described concerning the case where the main axis of the interconnector and the central axis of the notch overlap, the main axis of the interconnector and the central axis of the notch may be displaced from each other.

Here, in the case where the conductive member is sheet-shaped and has its width W16, W17 of approximately 2.5 mm and its thickness T16, T17 of approximately 0.20 mm, it is particularly preferable that S16, S17 are approximately 1 to 3 mm and D16, D17 are approximately 1 to 2.0 mm. Preferably, a minimum width of small cross-section part 7 is approximately 0.25 to 1.25 mm.

According to another aspect, the present invention provides a solar cell string including solar cells adjacent to each other and having electrodes respectively and an interconnector electrically connecting respective electrodes of the solar cells adjacent to each other, and the interconnector is the above-described interconnector of the present invention. Regarding the above-described solar cell string of the present invention, preferably each solar cell is rectangular and has each side of 155 mm or more. Further, regarding the above-described solar cell string of the present invention, preferably each solar cell has its thickness of 300 $\mu$m or less.

As the solar cell is larger and thinner, the problem of the warp of the solar cell becomes conspicuous. The interconnector as described above of the present invention is used to effectively reduce the warp occurring when the interconnector is connected, and thus the productivity is improved.

According to still another aspect, the present invention provides a method of manufacturing the above-described solar cell string of the present invention, including the step of connecting an electrode of a solar cell and a connecting portion of the interconnector by means of any one of heater heating, lamp heating and reflow method.

With this manufacturing method, the electrode of the solar cell and the connecting portion of the interconnector are connected using a method which is any of heater heating, lamp heating and reflow method, so that the interconnector is joined to the whole surface of the electrode of the solar cell and the long-term reliability of the completed module is improved.

Second Embodiment

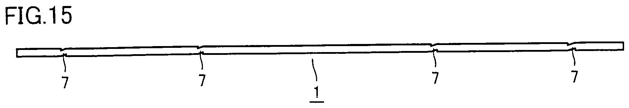

As a second embodiment, an embodiment of a solar cell string and a solar cell module to which the interconnector of the first embodiment is applied will be described with reference to Figs. 15 to 18.

According to still another aspect, the present invention provides a solar cell module including a solar cell string, an encapsulating material encapsulating the solar cell string and a pair of external terminals extending outward from the solar cell string through the encapsulating material, and the solar cell string is the above-described solar cell string of the present invention. The solar cell string is encapsulated in the encapsulating material to improve the environment resistance of the solar cell string. As the encapsulating material, for example, ethylene vinyl acetate copolymer is used.

The above-described solar cell module of the present invention may further include a surface protection layer of glass or polycarbonate on a light-receiving surface side and a rear film of acrylic resin on a rear side, and may further include a frame of aluminum around the module.

Further, the solar cell module of the present invention may any of various solar cell modules such as roof tile integrated module, slate integrated module or see-through type module.

An interconnector 1 shown in Fig. 15 is made for example using an electrically conductive member (copper wire) 3 that is solder-plated for example, has a maximum width W1 (see Fig. 1 (a)) of 2.5 mm and a maximum thickness T1 (see Fig. 1 (c)) of 0.20 mm As a material for the conductive member, any of other materials such as an alloy of copper-aluminum-copper or copper-indium-copper may be used.

As shown in Fig. 15, interconnector 1 includes a plurality of small cross-section parts 7. As shown in Fig. 1, for example, each small cross-section part 7 is formed by cutting each of two side surfaces 3a, 3b of conductive member 3 by approximately 0.75 mm in the width direction to form a curve. Small cross-section parts 7 are arranged in the longitudinal direction of conductive member 3 correspondingly to a silver electrode of a light-receiving surface and a silver electrode of a rear surface while avoiding these silver electrodes.

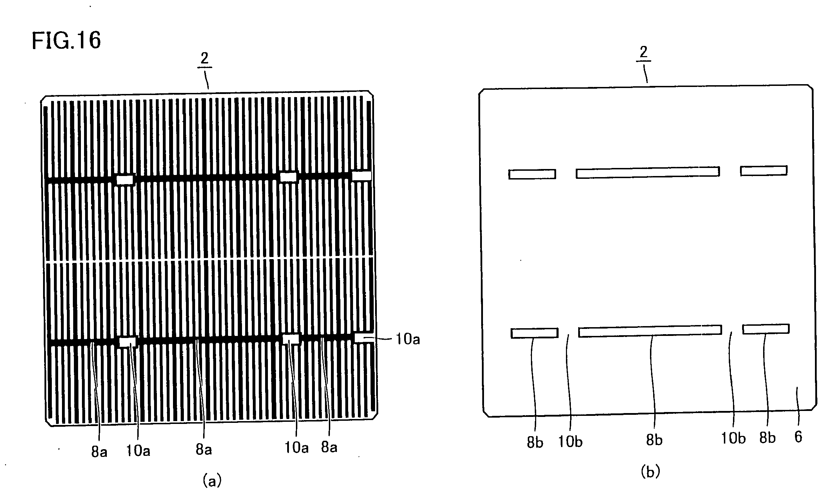

Fig. 16 (a) shows light-receiving surface electrodes of a solar cell, including a substantially parallel-arranged grid electrode and a light-receiving surface electrode 8a that is an interconnector joint electrode disposed substantially orthogonal to the grid electrode. Fig. 16 (b) shows rear electrodes of a solar cell including rear electrodes 8b that are a plurality of interconnector joint electrodes arranged substantially in parallel with each other in the shape of broken strips. Specifically, in terms of collecting electric power, preferably the front electrode or rear electrode is formed from one lateral end to the opposite lateral end of a semiconductor substrate, and the conductive member is preferably connected to the electrode from one lateral end to the opposite lateral end of the semiconductor substrate.

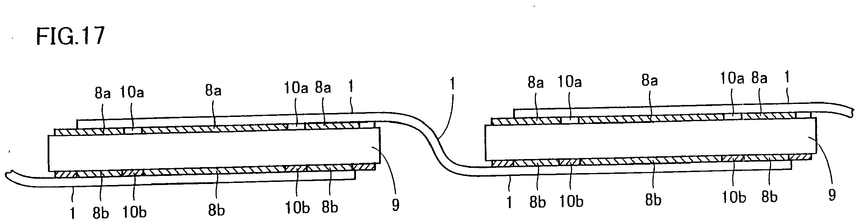

As shown in Fig. 16 (a), two gaps (non-connecting portions) 10a are provided around a central portion of the front electrode main grid and thus the main grid is divided into three sections. As shown in Fig. 16 (b), the design is made such that the portion where a rear silver electrode and an interconnector are connected on the rear side and a portion where a front silver electrode and an interconnector are connected on the front side are symmetrical to each other. Fig. 17 shows that interconnectors are connected to the solar cells thus designed. Namely, Fig. 17 shows that crystalline silicon solar cells of the first embodiment of the present invention are connected by the interconnectors. At the gap portion provided in the surface electrode main grid, the interconnector is not connected to the grid. Small cross-section part 7 of the interconnector is disposed at this gap portion. On the rear surface, the interconnector and the solar cell are not soldered at an aluminum electrode portion 6 and they are soldered at only the silver electrode portion. Here, the aluminum electrode is disposed at the small cross-section part 7 of the interconnector.

Further as shown in Fig. 17, the portion where the interconnector and the front silver electrode are connected on the front side and the portion where the interconnector and the rear silver electrode are connected on the rear side are disposed at exactly the same position, and accordingly a stress caused by a difference in thermal expansion coefficient between the interconnector and the solar cell on the front side and that on the rear side are substantially equal to each other. Therefore, the stress due to the thermal expansion coefficient between the cell and the interconnector that is one cause of occurrence of the warp of the solar cell is balanced between the front side and the rear side. Specifically, the above-described electrode pattern is provided and each small cross-section part 7 is disposed at the portion where each silver electrode and the interconnector are not connected, so that equal forces are applied to the solar cell from the front side and the rear side. With these effects, the warp of the solar cell is reduced and defective connection and occurrence of a cell crack can be prevented.

A process of connecting each silver electrode and an interconnector will be described. A solar cell 9 shown in Fig. 17 is structured using a polycrystalline silicon substrate having a side of 1 55 mm and a thickness of 200 $\mu$m for example. An interconnector connecting a plurality of solar cells 9 uses an electrically conductive member that is a long and thin wire material made of copper for example and covered with a solder, and the conductive member is continuously stored in a reeled state and cut into pieces each having a length as designed. The interconnector may have a stress relief part formed in advance and stored in a reel, or a stress relief part may be formed when the interconnector is cut from the reel.

Then, as shown in Fig. 17, interconnectors 1 and solar cells 9 having a silver electrode are alternately transported and set. Specifically, a rear electrode 8b of solar cell 9 is laid on interconnector 1, another interconnector 1 is laid on a light-receiving surface electrode 8a of this solar cell 9, and a rear electrode 8b of another solar cell 9 is laid on this interconnector 1 successively. In the state where required interconnectors and required solar cells are arranged, heater heating for example is performed to solder interconnector 1 and each silver electrode and thereby connect the interconnector and the electrode. Specifically, the interconnector connected to the main grid of the light-receiving surface extends onto the rear surface of an adjacent cell and connected to the rear surface silver electrode. In this way, a solar cell string 22 with a small warp is completed where a plurality of solar cells 2 are connected electrically to each other in a line by interconnectors 1.

Thus, the interconnectors as shown in Figs. 1 to 4 can be used to reduce a contraction stress exerted on the cell when the temperature is lowered in the process of connecting the interconnector. Specifically, the interconnector includes a region where the proof strength is partially weak and has a cross-sectional area that continuously changes in the longitudinal direction of the interconnector such that stress concentration and local breakage are avoided.

Further, the interconnectors as shown in Figs. 5 to 12 can be used to reduce a contraction stress exerted on the cell when the temperature is lowered in the process of connecting the interconnector. Specifically, the interconnector includes a region where the proof strength is partially weak, the interconnector is divided to have a cross-sectional area that changes dispersedly and the cross-sectional area that continuously changes in the longitudinal direction of the interconnector, such that stress concentration and local breakage are avoided.

In particular, the interconnectors as shown in Figs. 13 and 14 can be used to reduce a contraction stress exerted on the cell when the temperature is lowered in the process of connecting the interconnector. Specifically, the interconnector includes a region where the proof strength is partially weak, and the interconnector is divided to have a cross-sectional area dispersedly changes such that stress concentration and local breakage are avoided.

Further, in the case where the interconnectors as shown in Figs. 5 to 14 are used, the shape of the interconnector does not have any notch, at side surface portions 3a and 3b of conductive material 3, that is caught on something when the interconnector is fed in the process of connecting the interconnector and the solar cell. Therefore, the device transportation is facilitated and consequently the productivity can be improved.

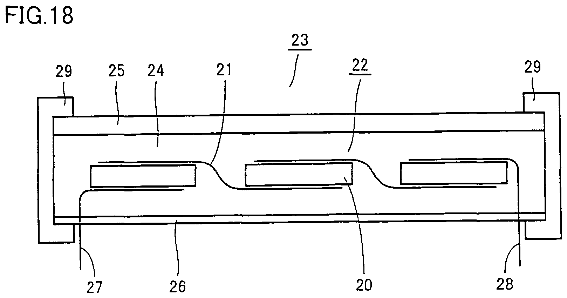

With reference to Fig. 18, a solar cell module 23 using above-described solar cell string 22 will be described.

As required, solar cell strings 22 are connected in series to each other using a relatively bold wire material called bus bar, and the cell strings thus connected are sandwiched between films of EVA (ethylene vinyl acetate) that is an encapsulating material 24, and thereafter sandwiched between a glass sheet that is a surface protection layer 25 and a back film that is a rear film 26 made of acrylic resin for example. Air bubbles entering between films are removed by decreasing the pressure (lamination) and heating (curing) is performed to harden the EVA and encapsulate solar cells 2. After this, an aluminum frame that is a frame 29 is fit on the four sides of the glass sheet, and a terminal box is connected to a pair of external terminals 27 and 28 extending outward from solar cell string 22. Thus, solar cell module 23 is completed.

As seen from the above, solar cell module 23 uses solar cell string 22 with a small warp, so that cracks of solar cells 2 are reduced in the encapsulation process with encapsulating material 24.

Third Embodiment

A third embodiment of the interconnector of the present invention will be described with reference to drawings. Regarding the shape of the interconnector in the third embodiment, the features common to those of the interconnector in the first embodiment will be described using the drawings referred to for the description of the first embodiment.

The interconnector in the third embodiment of the present invention is formed using a strip-shaped and electrically conductive member 3 as in the first embodiment, and preferably conductive member 3 is linearly shaped. More preferably, a stress relief part is planar-shaped and stress relief parts may be arranged in parallel without a space therebetween with respect to a surface of a solar cell.

The interconnector in the third embodiment is provided with a portion of a low proof stress over the whole or at least one part of the interconnector, and the low stress-proof portion is formed using an electrically conductive member having a 0.2% load of not more than 10.0 kgf. Further, preferably the interconnector in the present embodiment is formed entirely using the same conductive member.

Here, a solar cell 2 includes those formed using an elemental semiconductor such as amorphous silicon, polycrystalline silicon and monocrystalline silicon and a compound semiconductor such as GaAs, for example. Preferably, conductive member 3 is made of a strip-shaped electrically conductive material in the form of a foil or sheet and made of an electrically conductive material formed such that the material can be stored in reeled state.

In the case where the conductive member is strip-shaped, its width W is preferably approximately 0.5 to 5.0 mm, more preferably approximately 0.5 to 3.0 mm and particularly preferably approximately 2.5 mm Thickness T is preferably approximately 0.05 to 0.5 mm, more preferably approximately 0.05 to 0.3 mm and particularly preferably approximately 0.2 mm.

In the present embodiment, preferably solar cell 2 includes an electrode formed on a front surface or rear surface of a semiconductor substrate, the electrode is formed from one lateral end to the opposite lateral end of the semiconductor substrate, and conductive member 3 is connected to the electrode from one lateral end to the opposite lateral end of the semiconductor substrate. Further, one or both ends of the conductive member may be divided into multiple portions. For example, in the case where one of solar cells adjacent to each other has its light-receiving surface where a plurality of electrodes are provided and the other solar cell has its rear surface where one electrode is provided, an interconnector may be used that is formed using a conductive member having one end divided into a plurality of portions.

The conductive member includes various metals and alloys. Specifically, the conductive member includes metals such as Au, Ag, Cu, Pt, Al, Ni and Ti as well as alloys of them. In particular, Cu is preferably used. Preferably, the conductive member is solder-plated. A solder-plated interconnector is surely connected with a silver electrode of a solar cell.

An interconnector using a conductive member having a 0.2% load of not more than 10.0 kgf has a lower strength against expansion and contraction stresses as compared with a conventional interconnector having a 0.2% load of approximately 13 to 15 kgf, and thus is extended by a relatively weak force. Therefore, such an interconnector contributes to reduction of a warp of the solar cell by extension of the solar cell with the resilience of recovering its original shape.

The interconnector may be partially cut to have a small cross-section part so that the interconnector has an easily extendable structure, and may be provided partially with a low proof-strength portion to reduce the 0.2% load of the whole interconnector. The small cross-section part can be changed to adjust the 0.2% load to approximately 0.1 kgf or more. The small cross-section part of the present embodiment may be for example the shape as shown in Fig. 3 or 5.

In particular, regarding an interconnector using a conductive member having a 0.2% load of 10.0 kgf or less, the interconnector having its cross-sectional area continuously changing in the longitudinal direction as shown in Fig. 3 can be used to more effectively reduce a warp occurring to the solar cell and avoid breakage of the small cross-section part.

Further, regarding an interconnector using a conductive member having a 0.2% load of 10.0 kgf or less, the interconnector having its cross section whose cross-sectional area dispersedly changes as shown in Fig. 5 may be used to more effectively reduce a warp occurring to the solar cell and avoid breakage of the small cross-section part.

A description will be given of a relation between a 0.2% load and a wafer warp amount, using the above-described interconnector having a 0.2% load of 10.0 kgf or less.

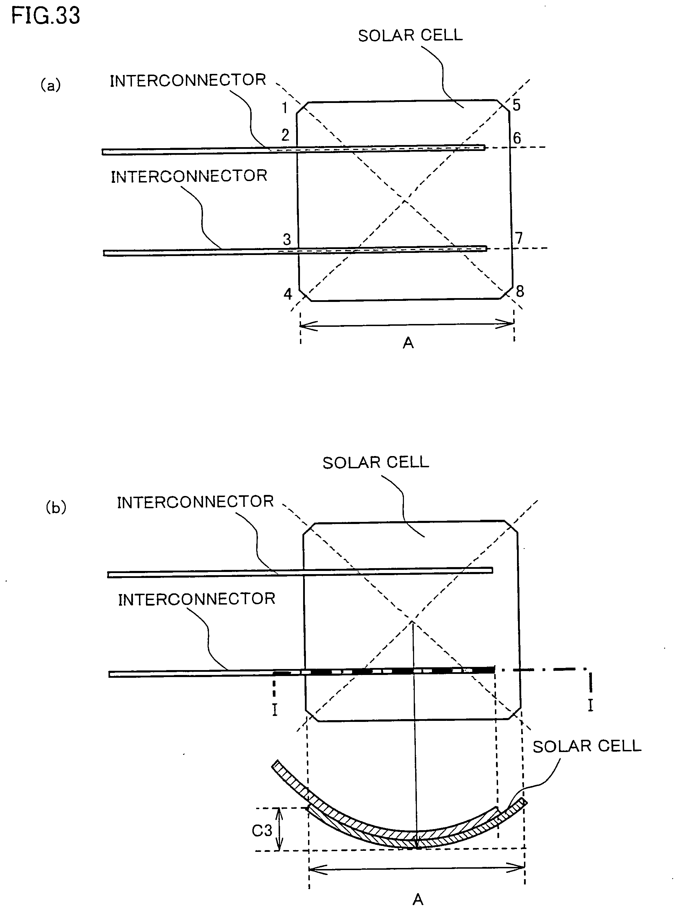

Table 1 shows the results of measurement of a wafer warp amount after an interconnector having a length L0 of 296 mm is soldered to an electrode of a solar cell that is substantially square, has a side A of 155 mm and a thickness B of a semiconductor substrate of 180 $\mu$m. The warp amount is measured as shown in the drawings at the four corners of the wafer and the four intersection points of the four sides of the wafer and the lines where two interconnectors are connected, namely measured at eight sites in total. The wafer warp amount is defined as a distance between a plane contacting the wafer center (the intersection point of the oblique broken lines in Fig. 33) and a wafer end, and the average of respective measurements at the eight sites (points 1 to 8) shown in Fig. 33 (a) is used as a warp amount C of the solar cell. A dimension C3 in Fig. 33 (b) represents the warp amount at point 3.

Table 1

| B=180um, A=155mm | | | | | | point 1 | point 2 | point 3 | point 4 | point 5 | point 6 | point 7 | point 8 |
|---|---|---|---|---|---|---|---|---|---|---|---|---|---|
| sample | W [mm] | T [mm] | F [kgf] | C/A [%] | C=ave(C1:C8) | C1 | C2 | C3 | C4 | C5 | C6 | C7 | C8 |
| 1 | 2.50mm | 0.20mm | 1.77kgf | 0.97 | 1.50mm | 1 | 2 | 1 | 1 | 1 | 2.5 | 2 | 1.5 |
| 2 | 2.50mm | 0.20mm | 3.62kgf | 1.57 | 2.44mm | 2 | 2.5 | 2 | 2 | 2.5 | 3 | 3 | 2.5 |
| 3 | 2.00mm | 0.20mm | 4.46kgf | 1.94 | 3.00mm | 2.5 | 2.5 | 3 | 2.5 | 3 | 3.5 | 3.5 | 3.5 |
| 4 | 2.50mm | 0.16mm | 6.18kgf | 2.46 | 3.81mm | 2 | 4 | 3 | 2 | 4.5 | 5 | 5.5 | 4.5 |
| 5 | 2.50mm | 0.20mm | 7.70kgf | 3.19 | 4.94mm | 2.5 | 5 | 4 | 4 | 5.5 | 6.5 | 6.5 | 5.5 |
| 6 | 2.50mm | 0.25mm | 9.67kgf | 3.67 | 5.69mm | 4 | 5.5 | 4.5 | 3.5 | 6 | 7 | 8 | 7 |
| 7 | 2.50mm | 0.28mm | 10.80kgf | 4.52 | 7.00mm | 5 | 7 | 6 | 5 | 7.5 | 8.5 | 9.5 | 7.5 |

A: substrate width [mm]

B: substrate thickness [$\mu$m]

F: 0.2% load [kgf]

W: interconnector width [mm]

T: interconnector thickness [mm]

C: warp amount of solar cell [mm]

In the case where C/A is used that is a value determined by dividing the average of respective warp amounts of the solar cell ends at the eight sites relative to the center of the solar cell in the longitudinal direction of the conductive member by the width of the solar cell in the longitudinal direction of the conductive member, wafer cracks in a module process (lamination process) due to the wafer warp are reduced in the case where C/A is within 4.0%. For example, in the case where A is 155 mm, warp amount C where wafer cracks are reduced is approximately 6.2 mm.

Samples 1 to 4 shown in Table 1 have C/A with respect to 0.2% load F as follows.

Sample 1: 0.2% load F = 1.77 kgf and C/A = 0.97%
Sample 2: 0.2% load F = 3.62 kgf and C/A = 1.57%
Sample 3: 0.2% load F = 4.46 kgf and C/A = 1.94%
Sample 4: 0.2% load F = 6.18 kgf and C/A = 2.46%
Sample 5: 0.2% load F = 7.70 kgf and C/A = 3.19%
Sample 6: 0.2% load F = 9.67 kgf and C/A = 3.67%
Sample 7: 0.2% load F = 10.8 kgf and C/A = 4.52%

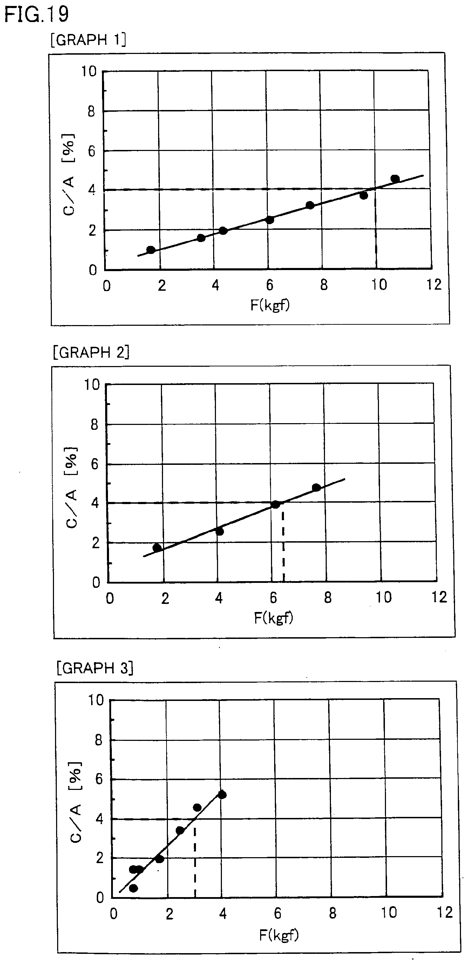

From the data, the relation of 0.2% load F - C/A as shown in Graph 1 of Fig. 19 is derived. The 0.2% load F with respect to which C/A is 4.0% is determined and this 0.2% load is approximately 10.0 kgf. Namely, for a substantially square solar cell having a side A of 155 mm and a thickness of the semiconductor substrate of 180 $\mu$m, cracks of the solar cell substrate are reduced as long as 0.2% load F is approximately 10.0 kgf or less.

Likewise, based on the data in the case where a solar cell has a side A of 155 mm and a thickness B of a semiconductor substrate of 160 $\mu$m as shown in Table 2, 0.2% load F where wafer cracks are reduced is derived from Graph 2 of Fig. 19. The resultant F is approximately 6.5 kgf or less.

Table 2

| B=160um, A=155mm | | | | | | point 1 | point 2 | point 3 | point 4 | point 5 | point 6 | point 7 | point 8 |
|---|---|---|---|---|---|---|---|---|---|---|---|---|---|
| sample | W[mm] | T[mm] | F[kgf] | C/A[%] | C=ave(C1:C8) | C1 | C2 | C3 | C4 | C5 | C6 | C7 | C8 |
| 8 | 2.50mm | 0.20mm | 1.77kgf | 1.77 | 2.75mm | 2 | 3 | 3 | 1 | 2.5 | 4 | 3.5 | 3 |
| 9 | 2.00mm | 0.20mm | 4.09kgf | 2.58 | 4.00mm | 3 | 3.5 | 4 | 3.5 | 4 | 5 | 4.5 | 4.5 |
| 10 | 2.50mm | 0.16mm | 6.18kgf | 3.91 | 6.06mm | 3.5 | 6.5 | 4.5 | 3 | 7.5 | 9.5 | 8 | 6 |
| 11 | 2.50mm | 0.20mm | 7.70kgf | 4.80 | 7.44mm | 4.5 | 8 | 5.5 | 3.5 | 9 | 11.5 | 10 | 7.5 |

Likewise, based on the data in the case where a solar cell has a side A of 155 mm and a thickness B of a semiconductor substrate of 120 $\mu$m as shown in Table 3, 0.2% load F where wafer cracks are reduced is derived from Graph 3 of Fig. 19. The resultant F is approximately 3.0 kgf or less.

Table 4

| B[um] | F[kgf] |
|---|---|
| 120 | 3.0 |
| 160 | 6.5 |
| 180 | 10.3 |

From Graph 4, the relation

$$F = 0.272e^{0.020B} \quad \text{... Expression (1)}$$

is derived. Namely, the interconnector satisfying the relation of Expression (1) may be used.

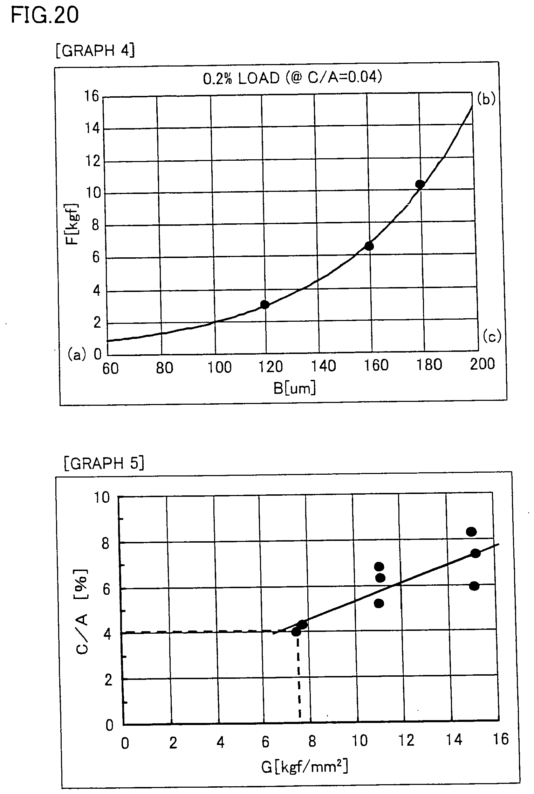

Further, regarding samples 19 to 26 that are each a conductive member without notch and having the same cross-sectional area and that are different in 0.2% load, namely for samples 19 to 26 having different 0.2% tensile stresses, based on the data in the case where a solar cell has a side A of 155 mm and a thickness B of a semiconductor substrate of 120 $\mu$m as shown in Table 5, a relation between 0.2% tensile stress G and C/A is shown in Graph 5 of Fig. 20. Here, "0.2% tensile stress" refers to a 0.2% load per unit area.

is derived. Namely, the interconnector satisfying the relation of Expression (1) may be used.

Further, regarding samples 19 to 26 that are each a conductive member without notch and having the same cross-sectional area and that are different in 0.2% load, namely for samples 19 to 26 having different 0.2% tensile stresses, based on the data in the case where a solar cell has a side A of 155 mm and a thickness B of a semiconductor substrate of 120 $\mu$m as shown in Table 5, a relation between 0.2% tensile stress G and C/A is shown in Graph 5 of Fig. 16. Here, "0.2% tensile stress" refers to a 0.2% load per unit area.

Table 5

| B=120um, A=155mm | | | | | | point 1 | point 2 | point 3 | point 4 | point 5 | point 6 | point 7 | point 8 |
|---|---|---|---|---|---|---|---|---|---|---|---|---|---|
| sample | W[mm] | T[mm] | G[kgf/mm2] | C/A[%] | C=ave(C1:C8) | C1 | C2 | C3 | C4 | C5 | C6 | C7 | C8 |
| 19 | 2.00mm | 0.20mm | 7.78kgf | 4.27 | 6.63mm | 5.5 | 6.5 | 6 | 5.5 | 7 | 7.5 | 8 | 7 |
| 20 | 2.00mm | 0.20mm | 7.50kgf | 3.99 | 6.19mm | 5.5 | 6.5 | 6 | 5.5 | 6 | 6.5 | 7 | 6.5 |
| 21 | 2.00mm | 0.20mm | 11.10kgf | 5.16 | 8.00mm | 7 | 8 | 8 | 7.5 | 8 | 8.5 | 9 | 8 |
| 22 | 2.00mm | 0.20mm | 11.15kgf | 6.77 | 10.50mm | 10 | 10 | 10.5 | 10 | 10.5 | 11.5 | 11 | 10.5 |
| 23 | 2.00mm | 0.20mm | 11.18kgf | 6.29 | 9.75mm | 9 | 9.5 | 10.5 | 10 | 9 | 10.5 | 10 | 9.5 |
| 24 | 2.00mm | 0.20mm | 15.10kgf | 5.89 | 9.13mm | 8 | 8 | 9 | 8 | 9 | 10 | 10.5 | 9.5 |
| 25 | 2.00mm | 0.20mm | 15.20kgf | 7.34 | 11.38mm | 11 | 12 | 11.5 | 10 | 11.5 | 12 | 12.5 | 10.5 |
| 26 | 2.00mm | 0.20mm | 15.05kgf | 8.27 | 12.81mm | 12 | 13 | 13.5 | 11.5 | 12 | 14.5 | 14 | 12 |

A: substrate width [mm]

B: substrate thickness [μm]

F: 0.2% load [kgf]

W: interconnector width [mm]

T: interconnector thickness [mm]

C: warp amount of solar cell [mm]

From Graph 5 of Fig. 20 based on the data in the case where the solar cell has a side A of 155 mm and a thickness B of a semiconductor substrate of 120 μm as shown in Table 5, 0.2% tensile stress G with respect to which C/A is 4.0% where wafer cracks are reduced is determined and the determined stress is approximately 7.5 kgf/mm$^2$ or less.

Further, 0.2% tensile stress G of the conductive member may be arbitrarily adjusted depending on a manufacturing process such as annealing, and the tensile stress may be any value as long as C/A ≤ 4.0% is satisfied.

Fourth Embodiment

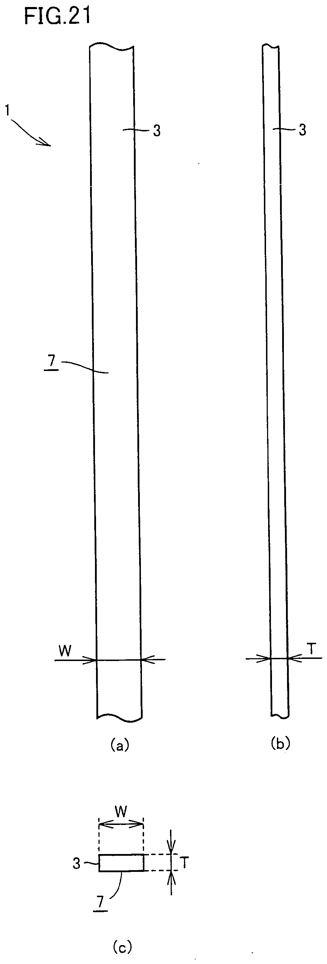

An interconnector according to a fourth embodiment of the present invention will be described with reference to Fig. 21.

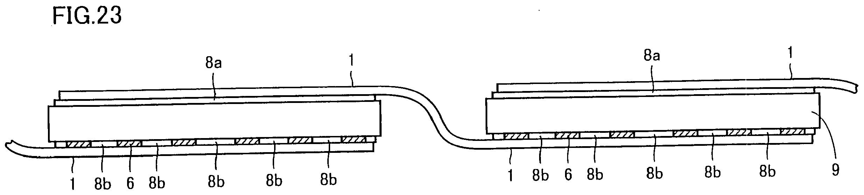

Interconnector 1 shown in Fig. 21 is made using a conductive member (copper wire) 3 that is solder-plated for example, and has a maximum width W (see Fig. 23 (a)) of 2.5 mm and a maximum thickness T (see Fig. 21 (b)) of 0.20 mm. As a material for the conductive member, another material such as a clad material of copper-aluminum-copper or copper-Inver-copper may be used.

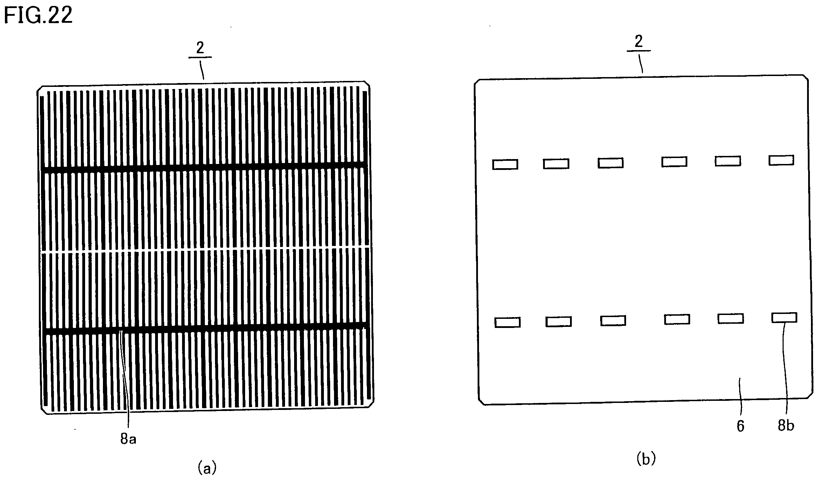

Fig. 22 (a) shows light-receiving surface electrodes of a solar cell, including a substantially parallel-arranged grid electrode and a light-receiving surface electrode 8a that is an interconnector joint electrode disposed substantially orthogonal to the grid electrode. Fig. 22 (b) shows rear electrodes of a solar cell including rear electrodes 8b that are a plurality of interconnector joint electrodes arranged substantially in parallel with each other in the shape of broken strips. Specifically, in terms of collecting electric power, preferably the front electrode or rear electrode is formed from one lateral end to the opposite lateral end of a semiconductor substrate, and preferably the conductive member is connected to the electrode from one lateral end to the opposite lateral end of the semiconductor substrate.

Fifth Embodiment

A fifth embodiment will be described regarding a process of connecting each silver electrode and the interconnector in the fourth embodiment. A solar cell 9 shown in Fig. 23 is structured for example using a polycrystalline silicon substrate having one side of 155 mm and a thickness of 180 μm for example. A low proof-stress interconnector connecting a plurality of solar cells 9 as used is produced by coating a long and thin wire material made of copper for example with a solder to produce an electrically conductive member, storing the conductive member continuously in reeled state and cutting the conductive member into pieces of a designed length.

Then, as shown in Fig. 23, interconnectors 1 and solar cells 9 having a silver electrode are alternately transported and set. Specifically, a rear electrode 8b of solar cell 9 is laid on interconnector 1, another interconnector 1 is laid on a light-receiving surface electrode 8a of this solar cell 9, and a rear electrode 8b of another solar cell 9 is laid on this interconnector 1 successively. In the state where required interconnectors and required solar cells are arranged, heater heating for example is performed to solder interconnector 1 and each silver electrode and thereby connect the interconnector and the electrode. Specifically, the interconnector connected to the main grid of the light-receiving surface extends onto the rear surface of an adjacent cell and connected to the rear surface silver electrode.

In this way, a solar cell string 22 with a small warp is completed where a plurality of solar cells 2 are connected electrically to each other in a line by interconnector 1. Such an interconnector having a low proof stress can be used to reduce a contraction stress applied to the cell when the temperature is lowered in the interconnector connecting process.

Thus, an interconnector having a 0.2% load of 10 kgf or less can be used to reduce a contraction stress applied to the cell when the temperature is lowered in the interconnector connecting process.

Further, an interconnector having a 0.2% load of 10 kgf or less and as shown in Figs. 3 and 5 can be used to effectively reduce a contraction stress applied to the cell when the temperature is lowered in the interconnector connecting process. Specifically, an interconnector divided to have a dispersedly changing cross-sectional area or having a continuously changing cross-sectional area in the longitudinal direction of the interconnector can be used to avoid stress concentration and local breakage of a conductive member having a 0.2% load of 10 kgf or less.

It should be construed that embodiments disclosed above are by way of illustration in all respects, not by way of limitation. It is intended that the scope of the present invention is defined by claims, not by the embodiments and examples above, and includes all modifications and variations equivalent in meaning and scope to the claims.

**Claims**

1. A solar cell string comprising:

   a plurality of solar cells (9) including electrodes (8a,8b); and
   an electrically conductive member (3) electrically connecting respective electrodes of said solar cells adjacent to each other,
   said electrically conductive member including at least two connecting portions connected to electrodes provided on one of a light receiving surface and a rear surface of one of said solar cells,
   said electrically conductive member being provided with a non-connecting portion located between said connecting portions and not physically connected to the electrodes of the solar cells, and
   said non-connecting portion includes at least one opening formed in said electrically conductive member, the opening having a configuration with its circumference closed.

2. The solar cell string according to claim 1, wherein said opening is rectangular or trapezoidal in shape.

3. The solar cell string according to claim 1, wherein said opening is circular or elliptical in shape.

4. The solar cell string according to claim 1, wherein at least one corner of said opening is curved.

5. A solar cell module comprising:

   the solar cell string as recited in claim 1;
   an encapsulating material encapsulating said solar cell string; and
   a pair of external terminals extending outward from said solar cell string through the encapsulating material.

**Patentansprüche**

1. Solarzellenkette, umfassend:

   eine Vielzahl von Solarzellen (9), die Elektroden (8a, 8b) enthalten; und
   ein elektrisch leitfähiges Bauteil (3), das jeweilige Elektroden der Solarzellen, die einander benachbart sind, elektrisch verbindet,
   wobei das elektrisch leitfähige Bauteil zumindest zwei verbindende Teile enthält, die mit Elektroden verbunden sind, die auf einer einer lichtempfangenden Oberfläche und einer rückwärtigen Oberfläche einer der Solarzellen vorgesehen sind,

wobei das elektrisch leitfähige Bauteil mit einem nicht-verbindenden Teil versehen ist, der zwischen den verbindenden Teilen gelegen und mit den Elektroden der Solarzellen nicht physisch verbunden ist, und der nicht-verbindende Teil zumindest eine Öffnung enthält, die in dem elektrisch leitfähigen Bauteil ausgebildet ist, wobei die Öffnung eine Ausgestaltung aufweist, deren Umfang geschlossen ist.

2. Solarzellenkette nach Anspruch 1, wobei die Öffnung in der Form rechtwinkelig oder trapezförmig ist.

3. Solarzellenkette nach Anspruch 1, wobei die Öffnung in der Form kreisförmig oder elliptisch ist.

4. Solarzellenkette nach Anspruch 1, wobei zumindest eine Ecke der Öffnung gebogen ist.

5. Solarzellenmodul, umfassend:

   die Solarzellenkette nach Anspruch 1;
   ein Einkapselungsmaterial, das die Solarzellenkette einkapselt; und
   ein Paar externe Anschlüsse, die sich von der Solarzellenkette durch das Einkapselungsmaterial nach außen erstrecken.

**Revendications**

1. Chaîne de cellules solaires comprenant :

   une pluralité de cellules solaires (9) comprenant des électrodes (8a, 8b) ; et
   un organe électroconducteur (3) connectant électriquement les électrodes respectives desdites cellules solaires adjacentes les unes aux autres,
   ledit organe électroconducteur comprenant au moins deux parties de connexion connectées à des électrodes disposées sur une surface parmi une surface de réception de lumière et une surface arrière de l'une desdites cellules solaires,
   ledit organe électroconducteur étant pourvu d'une partie sans connexion située entre lesdites parties de connexion et non connectée physiquement aux électrodes des cellules solaires, et
   ladite partie sans connexion comprend au moins une ouverture formée dans ledit organe électroconducteur, l'ouverture ayant une configuration avec sa circonférence fermée.

2. Chaîne de cellules solaires selon la revendication 1, dans laquelle ladite ouverture est de forme rectangulaire ou trapézoïdale.

3. Chaîne de cellules solaires selon la revendication 1, dans laquelle ladite ouverture est de forme circulaire ou elliptique.

4. Chaîne de cellules solaires selon la revendication 1, dans laquelle au moins un coin de ladite ouverture est incurvé.

5. Module de cellule solaire comprenant :

   la chaîne de cellules solaires selon la revendication 1 ;
   un matériau d'encapsulation encapsulant ladite chaîne de cellules solaires ; et
   une paire de bornes externes s'étendant vers l'extérieur depuis ladite chaîne de cellules solaires à travers le matériau d'encapsulation.

FIG.1

(a)

(b)

(c)

17

FIG.2

(a)

(b)

(c)

FIG.3

(a)

(b)

(c)

(d)

OBTUSE ANGLE

OBTUSE ANGLE

FIG.4

(a)

(b)

(c)

## FIG.5

(a)

(b)

(c)

## FIG.6

(a)          (b)

(c)

# FIG.7

(a)

(b)

(c)

FIG.8

(a)

D11

X11

S11

Z11

7

W11

(b)

3

S11

7

T11

(c)

W11   3b

3a

T11

7

D11

FIG.9

(a)

3

D12    S12

X12    7

Z12

W12

(b)

3

S12

7

T12

(c)

W12    3b

3a    T12

7

D12

## FIG.10

(a)

D13

X13

Z13

W13

S13

7

3

(b)

S13

7

3

T13

(c)

W13    3b

3a

7

T13

D13

FIG.11

(a)

(b)

(c)

## FIG.12

(a)

(b)

(c)

# FIG.13

(a)

(b)

(c)

## FIG.14

(a)

(b)

(c)

FIG.15

7    7    1    7    7

FIG.16

(a)

(b)

EP 1 947 703 B1

FIG.17

FIG.18

## FIG.19

[GRAPH 1]

[GRAPH 2]

[GRAPH 3]

FIG.20

[GRAPH 4]

0.2% LOAD (@ C/A=0.04)

[GRAPH 5]

## FIG.21

(a)

(b)

(c)

FIG.22

(a)

(b)

EP 1 947 703 B1

FIG.23

EP 1 947 703 B1

FIG.24

11

FIG.25

(a)

(b)

EP 1 947 703 B1

EP 1 947 703 B1

FIG.26

18a    11

18a    11

11  18b  16  18b    18b    18b    18b

11  18b  16  18b    18b    18b    18b    19

FIG.27

FIG.28

35

31

37 37 37 37 37 33

FIG.29

31

33

39 37 37 37 37 37

FIG.30

31

37 37 37 37 37

33

39

FIG.31

FIG.32

INTERCONNECTOR (BEFORE LOADED)

LOAD                    $L1 = L0 * 1.002$                    LOAD

L0

L1

INTERCONNECTOR (AFTER LOADED)

# FIG.33

(a)

INTERCONNECTOR

SOLAR CELL

1 2

5 6

INTERCONNECTOR

3

7

4

8

A

(b)

INTERCONNECTOR

SOLAR CELL

INTERCONNECTOR

I

I

SOLAR CELL

C3

A

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005142282 A
- DE 3902838 A1
- DE 4330282 A1
- US 6034322 A